# EUROPÄISCHE PATENTSCHRIFT

(11) **EP 2 497 344 B1**
(45) Veröffentlichungstag und Bekanntmachung des Hinweises auf die Patenterteilung: **11.12.2013**
(21) Anmeldenummer: 10768873.1
(22) Anmeldetag: 12.10.2010
(51) Int. Cl.: H05K 3/12, H05K 3/22, G01B 11/06, G01B 11/25, H05K 1/02, H05K 3/34

(54) **VERFAHREN UND VORRICHTUNG ZUM BEDRUCKEN EINES SUBSTRATS, INSBESONDERE EINER LEITERPLATTE, MIT EINER DRUCKPASTE**
PROCESS AND APPARATUS FOR PRINTING A SUBSTRATE, IN PARTICULAR A PRINTED CIRCUIT BOARD, WITH A PRINTING PASTE
PROCÉDÉ ET DISPOSITIF POUR IMPRIMER UN SUBSTRAT, EN PARTICULIER UN CIRCUIT IMPRIMÉ, AVEC UNE PÂTE À IMPRIMER

(30) Priorität: 06.11.2009 DE 102009053575
(43) Veröffentlichungstag der Anmeldung: 12.09.2012
(73) Patentinhaber: Ekra Automatisierungssysteme GmbH, 74357 Bönnigheim (DE)
(72) Erfinder: VEGELAHN, Torsten, 75447 Sternenfels (DE)
(74) Vertreter: Grosse, Rainer
(86) Internationale Anmeldenummer: PCT/EP2010/006229
(87) Internationale Veröffentlichungsnummer: WO 2011/054432

(56) Entgegenhaltungen:
- EP-A1- 2 071 278
- EP-B1- 1 314 342
- EP-B1- 1 541 002
- WO-A1-02/05607
- WO-A1-2005/083402
- WO-A1-2007/116848
- WO-A2-2004/082345
- FR-A1- 2 845 520
- GB-A- 2 353 759

## Beschreibung

Die Erfindung betrifft ein Verfahren zum Bedrucken eines Substrats, insbesondere einer Leiterplatte, mit einer Druckpaste mittels Siebdruckverfahren und eine optische Prüfung des Druckergebnisses. Die Erfindung betrifft ferner eine Druckeinrichtung, insbesondere Platinendrucker, sowie eine Inspektionseinheit für eine solche Druckeinrichtung.

Verfahren zum Bedrucken eines Substrats mit einer Druckpaste, insbesondere zum Bedrucken von Leiterplatten mit Lotpaste, sind bekannt. Solche Verfahren werden in Druckeinrichtungen wie insbesondere Platinendruckern angewandt, um Leiterplatten mit Lotpaste für die nachfolgende Bestückung mit elektrischen und elektronischen Bauteilen zu bedrucken. In der Druckeinrichtung wird das Substrat relativ zu einer Druckschablone ausgerichtet, beispielsweise mittels Passermarken, die über eine optische Erfassungseinrichtung erfasst und in die gewünschte Relativlage zueinander gebracht werden, wobei zur Ausrichtung Druckschablone und Substrat relativ zueinander verschoben werden. Durch die Druckschablone hindurch wird nach Auflegen der Druckschablone auf das Substrat Lotpaste auf das Substrat aufgedruckt. Das Substrat wird sodann von der Druckschablone getrennt, diese also beispielsweise abgehoben, und aus der Druckmaschine ausgeschleust. Dieser Vorgang wird für jedes weitere Substrat sequenziell wiederholt, so dass in einem Endlosbetrieb eine Vielzahl von Substraten hintereinander in gleicher Weise bedruckt wird. Hierbei ist es bekannt, dass Flächen- oder Zeilenkameras eine zweidimensionale Erfassung des Substrats nach der Bedruckung vornehmen und hierbei prüfen, ob die zu bedruckende Fläche des Substrats in der gewünschten Art und Weise bedruckt wurde. Diese optische Prüfung kann keine Aussage zur Bedruckungsstärke treffen, also zur Stärke des Druckauftrags auf das Substrat. Eine vollständige oder partielle Bedeckungskontrolle beziehungsweise eine Bedeckungskontrolle mit Höhenbewertung ist außerhalb der Druckeinrichtung bekannt. Hieran ist nachteilig, dass nur noch eine Entscheidung darüber getroffen werden kann, ob der Druckvorgang erfolgreich war, in dem Sinne, dass die spezifikationsgemäßen Toleranzen eingehalten sind, oder ob der Druckvorgang nicht erfolgreich war, das bedruckte Substrat also als Ausschuss ausgeschieden werden muss. Findet ein Test erst nach zumindest teilweiser Bestückung der Platine und zumindest außerhalb der Druckmaschine statt, können Fehler des Bedruckungsvorganges nicht mehr oder nur sehr erschwert korrigiert werden. Ungünstigstenfalls ist die Platine wertlos und muss entsorgt werden. Aus dem Stand der Technik sind auch die Dokumente WO-A1-2007116848, EP-B1-1314342, WO-A1-2002005607 und EP-B1-1541002 bekannt.

Diese Nachteile werden vorteilhaft durch das erfindungsgemäße Verfahren und die erfindungsgemäße Inspektionseinheit für eine Druckeinrichtung sowie die erfindungsgemäße Druckeinrichtung vermieden.

Es wird ein Verfahren gemäß Anspruch 1 vorgeschlagen zum Bedrucken eines Substrats, insbesondere einer Leiterplatte, mit einer Druckpaste, insbesondere Lotpaste, mit folgenden Schritten:
- Auflegen einer Druckschablone auf das Substrat,
- Bedrucken des Substrats in Siebdrucktechnik durch Öffnungen der Druckschablone hindurch zur Erzielung von mindestens einer aus Druckpaste bestehenden Druckstruktur,
- Trennen von Druckschablone und Substrat durch Abheben dieser Teile voneinander,
- Einfahren einer optischen Inspektionseinheit zwischen Druckschablone und Substrat,
- Prüfen der Druckstruktur hinsichtlich ihrer Druckpastendicke mittels der Inspektionseinheit,
- Beendigen des Bedruckens, wenn das Druckergebnis mindestens einer Vorgabe entspricht.

Die Inspektionseinheit wird auch für ein Ausrichten von Druckschablone und Substrat relativ zueinander verwendet.

Ein solches Ausrichten von Druckschablone und Substrat erfolgt vor der Bedruckung, um die korrekte Positionierung der zu erstellenden Druckstrukturen auf dem Substrat sicherzustellen. Die Inspektionseinheit weist hierzu bevorzugt jeweils eine Blickrichtung sowohl in Richtung auf die Druckschablone als auch in Blickrichtung auf das Substrat auf. Auf diese Weise ist es sehr vorteilhaft möglich, separate Ausricht- und Positionserfassungseinrichtungen für Druckschablone und Substrat einzusparen. Die Inspektionseinheit kann hierzu die Funktion des Erkennens der jeweiligen Position von Druckschablone und Substrat, nämlich insbesondere in Horizontalrichtung relativ zueinander, wahrnehmen.

Wie im Stand der Technik bekannt, wird die Druckpaste / Lotpaste in Siebdrucktechnik durch Öffnungen der Druckschablone auf das Substrat aufgebracht, wodurch sich mindestens eine Druckstruktur ausbildet, also ein Bereich auf dem Substrat mit Druckpaste / Lotpaste in bestimmter Auftragsstärke bedeckt wird. Sodann werden Druckschablone und Substrat voneinander getrennt, was durch Abheben dieser Teile voneinander geschieht. Hierbei ist gemeint, dass die Teile in vertikaler Richtung voneinander getrennt werden, nämlich in einer solchen Art und Weise, dass ein Horizontalversatz nicht oder nicht in für das Bedrucken relevanter Weise auftritt. Das Abheben kann hierbei dadurch erfolgen, dass das Substrat in unveränderter Lage bleibt und die Druckschablone vom Substrat abgehoben, also angehoben, wird, sofern die Bedruckung von oben erfolgt, oder aber, dass die Druckschablone zumindest im Wesentlichen unverändert bleibt, und das Substrat abgesenkt wird. Maßgeblich ist allein, dass eine vertikal erfolgende Trennung ohne relevanten Horizontalversatz erfolgt. Zwischen die so voneinander abgehobenen Druckschablonen und Substrat wird die optische Inspektionseinheit eingefahren und mittels ihrer die Druckstruktur hinsichtlich ihrer Druckpastendicke geprüft. Entspricht hierbei das Druckergebnis, wie es bei diesem Prüfen festgestellt wurde, mindestens einer Vorgabe, wird das Bedrucken beendet. Anders als im Stand der Technik kann mit dem hier vorgeschlagenen Verfahren das Druckergebnis in Hinblick auf die Stärke des Druckspastenauftrags, also hinsichtlich der Druckpastendicke, bereits innerhalb der Druckeinrichtung, beispielsweise im Platinendrucker, geprüft werden, und zwar in einer solchen Art und Weise, dass Druckschablone und Substrat nicht in horizontaler Richtung voneinander getrennt werden, sondern nach wie vor nur vertikal in einer solchen Art und Weise getrennt sind, dass sie die für das Bedrucken erforderliche Ausrichtung relativ zueinander beibehalten und lediglich einen Abstand zueinander aufweisen, in den die Inspektionseinheit einfährt.

In einer vorteilhaften Verfahrensausbildung ist weiter vorgesehen, dass ein mindestens einmaliges Korrigieren der Bedruckung durch nochmaligen Bedruckungsvorgang nach vorherigem Herausfahren der Inspektionseinheit - aus der Position zwischen Druckschablone und Substrat erfolgt, falls die Vorgabe nicht erreicht ist. Anschließend hieran erfolgt ein nochmaliges Prüfen mittels der Inspektionseinheit. Diese beiden Schritte können sooft an demselben Substrat wiederholt werden, bis das Druckergebnis der Vorgabe entspricht. Aufgrund der vorstehend beschriebenen, während der Prüfung gleichbleibenden horizontalen Relativausrichtung von Druckschablone und Substrat kann sehr einfach die Bedruckung wiederholt werden, indem der Bedruckungsvorgang noch einmal durchgeführt wird. Hierzu wird die Inspektionseinheit aus der für das Prüfen erforderlichen Position zwischen Druckschablone und Substrat herausgefahren und die Druckschablone wieder auf das Substrat aufgelegt, was aufgrund des Umstandes, dass eine Horizontalverschiebung dieser beiden Teile relativ zueinander nicht erfolgt ist, möglich ist. Das Korrigieren der Bedruckung kann hierbei einen Minderauftrag korrigieren, indem noch einmal Lotpaste aufgebracht wird, also durch Öffnungen der Druckschablone hindurch zur Erzielung der gewünschten Druckstruktur auf das Substrat aufgebracht wird, oder indem zuviel aufgebrachte Lotpaste durch die Druckschablone hindurch abgenommen wird. Dies ist beispielsweise durch einfaches Überfahren mittels des in der Siebdrucktechnik bekannten Rakels möglich. Zuviel aufgebrachte Lotpaste, die zu einer unerwünschten Höhe des Druckauftrags führt, durchdringt nämlich die Öffnungen der Druckschablone an den entsprechenden Stellen und kann durch das sie überstreichende Rakel abgenommen werden. Selbstverständlich ist es auch möglich, in einem Vorgang sowohl Lotpaste aufzutragen als auch zuviel aufgebrachte Lotpaste abzutragen. Hierbei werden diese Schritte des Korrigierens der Bedruckung und des wiederholten Prüfens mittels der Inspektionseinheit sooft hintereinander ausgeführt, bis das Druckergebnis der Vorgabe entspricht. Erst dann wird das bedruckte Substrat auch in Horizontalrichtung von der Druckschablone getrennt, die horizontale Relativausrichtung von Druckschablone und Substrat also aufgegeben und aus der Druckeinrichtung ausgefahren.

In einer besonders bevorzugten Ausführungsform ist vorgesehen, dass das Prüfen unter Zuhilfenahme einer Streifenlichtprojektion durchgeführt wird. Bei der Streifenlichtprojektion wird mindestens ein Streifenmuster statisch oder veränderlich auf das zu prüfende Objekt, hier die Druckstruktur, schräg projiziert und die so auf der Druckstruktur erfolge Projektion von einem Detektor, beispielsweise von einer Kamera oder von mehreren Kameras, erfasst. Über das Triangulationsprinzip werden die dreidimensionalen Koordinaten der so erfassten Oberfläche errechnet.

In einer Verfahrensausbildung ist vorgesehen, dass das Prüfen an einem zuvor festlegbaren Abschnitt der Druckstruktur und/oder des Substrats erfolgt. Prinzipiell ist es möglich, das Prüfen der Druckstrukturen über die gesamte Fläche der Druckstrukturen und/oder des Substrats durchzuführen, insbesondere mittels der Streifenlichtprojektion eine vollständige Prüfung auf die erforderliche Druckauftragsstärke/Lotpastenstärke durchzuführen. Hierbei wird für die gesamte Bedruckung des Substrats ein zuverlässiges Prüfergebnis gewonnen. Da die Durchführung einer Prüfung mittels Streifenlichtprojektion allerdings einen gewissen Zeitaufwand erfordert, wird vorteilhaft das Prüfen an kritischen, repräsentativen Abschnitten der Druckstruktur und/oder des Substrats durchgeführt und vom Ergebnis dieser Prüfung auf die Gesamtdruckqualität geschlossen oder aber die Gesamtdruckqualität nur in Hinblick auf diesen Abschnitt betrachtet. Hierzu eignen sich insbesondere solche Abschnitte, die eine besonders kritische Ausbildung aufweisen.

In einer weiteren, besonders bevorzugten Verfahrensausbildung erfolgt eine Prüfung der Fläche der Druckstruktur mittels der Inspektionseinheit. Es wird hierbei nicht nur die Druckstruktur in Hinblick auf die Druckauftragstärke, also die aufgetragene Lotpastenstärke, geprüft, insbesondere im Streifenlichtprojektionsverfahren, wie vorstehend beschrieben, sondern auch die Flächenerstreckung der Druckstruktur, insbesondere in Hinblick auf ihre korrekte geometrische flächige Ausrichtung und Ausbildung. Hierbei wird erkannt, ob Fehlstellen und/oder unerwünschte Verläufe vorhanden sind. Gleichzeitig kann hierbei eine Überprüfung der Fläche des Substrats erfolgen, ob die Bedruckung des Substrats in der gewünschten Weise erfolgt ist, also das gewünschte Druckmuster erzielt wurde (2D-Prüfung).

Weiter wird eine Inspektionseinheit gemäß Anspruch 6 vorgeschlagen für eine Druckeinrichtung zum Bedrucken eines Substrats, insbesondere einer Leiterplatte, mit einer Druckpaste, insbesondere Lotpaste, wobei die Inspektionseinheit dem optischen Prüfen einer Druckstruktur dient und zwischen einer Druckschablone und dem Substrat ein- und ausfahrbar angeordnet ist. Dabei ist mindestens eine Streifenlichtprojektionseinrichtung vorgesehen, die mindestens ein Linienmuster schräg auf die zu prüfende Druckstruktur wirft, und mindestens ein Detektor zur Erfassung des Linienmusters auf der Druckstruktur. Die Streifenlichtprojektionseinrichtung erlaubt durch die schräge Projektion des mindestens einen Linienmusters auf die Druckstruktur eine dreidimensionale Prüfung eben dieser Druckstruktur, insbesondere eine Höhenprüfung im Sinne einer Prüfung einer Druckauftragsstärke. Durch die Schrägprojektion wird bei Auftreffen des Linienmusters auf die Druckstruktur eine Veränderung dieses Linienmusters bewirkt, die von dem mindestens einen Detektor erfasst wird. Aus dieser Veränderung des projizierten Linienmusters lassen sich die dreidimensionalen Koordinaten der so betrachteten Druckstruktur im Wege einer Triangulation berechnen, so dass Aussagen über die Höhe der Druckstruktur über dem Substrat, also letztlich über die Stärke des Druckauftrags, getroffen werden können.

Die Inspektionseinheit wird auch für ein Ausrichten von Druckschablone und Substrat relativ zueinander verwendet.

In einer bevorzugten Ausführungsform weist die Inspektionseinheit mindestens eine Spiegeleinrichtung auf, die mindestens einen teildurchlässigen Spiegel aufweist, der im Strahlengang der Inspektionseinheit liegt. Durch eine solche Spiegeleinrichtung ist es möglich, einen einzelnen Detektor in mehrere Blickrichtungen, die von der Inspektionseinheit abgehen, blicken zu lassen, insbesondere in entgegengesetzte Blickrichtungen, die bei einem Einfahren der Inspektionseinheit zwischen Druckschablone und Substrat den Blick beispielsweise nach oben zur Druckschablone und nach unten auf das Substrat gestatten. Auf diese Weise wird die Verwendung der Inspektionseinheit als Positionserkennungs- und Ausrichteinheit vor Durchführung des Bedruckens (nämlich vor Absenken der Druckschablone auf das Substrat) möglich, so dass eine separate Positionserfassungseinrichtung entfallen kann. Weiter kann so, solange die Inspektionseinheit zwischen Druckschablone und das Substrat eingeschoben ist, ein beständiger Abgleich der Horizontalpositionen von Druckschablone und Substrat erfolgen. Derselbe Detektor kann über die Spiegeleinrichtung zur Durchführung der Streifenlichtprojektion und Erfassung des auf die Druckstruktur projizierten Musters, also zum Prüfen, wie vorstehend beschrieben, verwendet werden. Auf diese Weise lässt sich eine kompakte, Bauteile sparende Inspektionseinheit bewerkstelligen, die bevorzugt in ein thermisch isolierendes und/oder klimatisiertes, kompaktes Gehäuse eingehaust ist. Die Inspektionseinheit kann in einer solchen Ausgestaltung vorteilhaft im Platinendrucker zur Durchführung der Prüfung innerhalb des Platinendruckers angeordnet werden.

In einer weiteren bevorzugten Ausführungsform weist die Inspektionseinheit eine Auswerteeinrichtung zur Auswertung eines vom Detektor erfassten Bildes auf. Mittels der Auswerteeinrichtung ist die Inspektionseinheit in der Lage, das vom Detektor erfasste Bild selbst auszuwerten. Das erfasste Bild kann hierbei eine Position von Druckvorlage und Substrat beziehungsweise von Druckvorlage und Substrat relativ zueinander oder relativ zu Fixmarken, wie sie beispielsweise an der Druckeinrichtung selbst angebracht sein können, zeigen, oder das vom Detektor erfasste Bild des mindestens einen Linienmusters, wie es auf die Druckstruktur projiziert wird, beziehungsweise wie es von der das Linienmuster erzeugenden Lichtquelle selbst ausgestrahlt wird. Die Auswerteeinrichtung liefert demzufolge verwertbare, für eine nachfolgend geschaltete Steuerung als Daten weiterverwendbare Ergebnisse. Eine solche Auswerteeinrichtung wird bevorzugt durch eine elektronische Schaltung, beispielsweise einen Mikrocontroller und entsprechende Software, realisiert.

In einer weiteren Ausführungsform weist die Inspektionseinheit eine Steuerschnittstelle auf zur Ansteuerung der Druckeinrichtung in Abhängigkeit von einem Ergebnis einer von der Auswerteeinrichtung durchgeführten Auswertung. In dieser Ausführungsform ist die Auswerteeinrichtung in der Lage, die Ansteuerung der Druckeinrichtung selbst vorzunehmen, insbesondere selbst Steuerbefehle an die Druckeinrichtung abzugeben. In einer solchen, gewissermaßen ein intelligentes System darstellenden Ausführungsform der Inspektionseinheit wird die Steuereinrichtung zumindest teilweise von der Auswerteeinrichtung der Inspektionseinheit gesteuert, beispielsweise in Hinblick darauf, ob ein Druckvorgang zu wiederholen ist, weil die Auswertung des vom Detektor erfassten Bildes ergeben hat, dass die gewünschte Druckqualität nicht erreicht wurde, also nicht der mindestens einen Vorgabe entspricht, wie vorstehend beschrieben.

Weiter wird eine Druckeinrichtung vorgeschlagen, insbesondere ein Platinendrucker, mit einer Inspektionseinheit, wie vorstehend beschrieben, insbesondere zur Durchführung des Verfahrens zum Bedrucken eines Substrats, wie vorstehend beschrieben. Eine solche Druckeinrichtung kann als Stand-alone-Gerät und in sich abgeschlossen die Bedruckung einschließlich vollständiger Qualitätskontrolle und Korrektur der Bedruckung durchführen, wobei aufgrund der sofortigen Qualitätskontrolle des Bedruckungsvorgangs und unmittelbar anschließender Korrektur eines möglicherweise nicht zufriedenstellenden Druckvorgangs eine Ausschussproduktion sehr vorteilhaft vermieden wird und eine hohe gleichbleibende Druckqualität sichergestellt ist.

Weitere vorteilhafte Ausführungsformen ergeben sich aus den Unteransprüchen und aus Kombinationen derselben.

Die Erfindung wird nachfolgende anhand eines Ausführungsbeispiels näher erläutert, ohne aber hierauf beschränkt zu sein.

Es zeigen
- Figur 1: eine schematische Längsschnittdarstellung einer Druckeinrichtung mit Inspektionseinheit und
- Figur 2: eine schematische Darstellung einer Inspektionseinheit während des Prüfens eines Druckergebnisses.

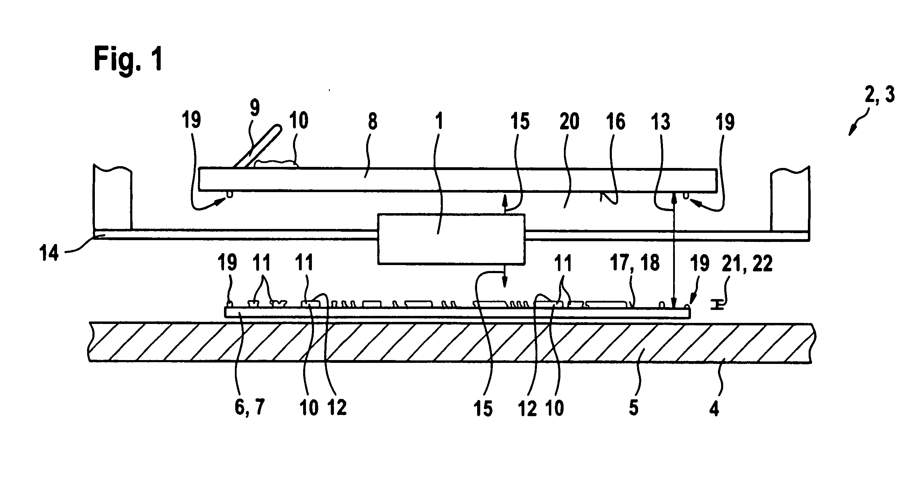

Figur 1 zeigt in schematischer Längsschnitt-Darstellung eine Inspektionseinheit 1 in einer hier nur abschnittsweise gezeigten Druckeinrichtung 2, nämlich einem Platinendrucker 3. Die Druckeinrichtung 2 weist einen Drucktisch 4 als Abstützung 5 für das zu bedruckende Substrat 6, nämlich eine Leiterplatte 7, auf, auf dem das Substrat 6 für die Bedruckung in der Druckeinrichtung 2 gehalten ist. Die Druckeinrichtung 2 weist ferner eine im Wesentlichen vertikal oberhalb des zu bedruckenden Substrats 6 angeordnete Druckschablone 8 auf, die mittels einer lediglich symbolisch dargestellten Rakeleinrichtung 9 Lotpaste 10 durch die Druckschablone 8 beim Bedruckungsvorgang auf das Substrat 6 aufträgt. Gezeigt ist die Situation nach dem Bedruckungsvorgang, bei dem Lotpaste 10 durch das Bedrucken auf dem Substrat 6 Druckstrukturen 11, nämlich Pads 12, aus aufgedruckter Lotpaste 10, ausgebildet hat. Nach dem Bedruckungsvorgang befinden sich, ebenso wie vor dem Bedruckungsvorgang, Druckschablone 8 und Substrat 6 in vertikal voneinander beabstandeter, abgehobener Position. Zwischen ihnen ist ein Vertikalabstand 13 vorhanden, in den die Inspektionseinheit 1 über eine Verschiebevorrichtung 14 eingefahren wird, die eine X-N-Verschiebung, also eine zweidimensionale Verstellung der Position der Inspektionseinheit 1, zulässt. Die Inspektionseinheit 1 wird hierbei in einer Ebene zweidimensional verschoben, um sowohl Druckschablone 8 als auch Substrat 6 optisch erfassen zu können. Die Inspektionseinheit 1 hat hierzu zwei im Wesentlichen entgegengesetzt gerichtete Blickrichtungen 15, nämlich bevorzugt senkrecht aus der Ebene ihrer X-/Y-Verstellung herausgerichtet nach oben, in Richtung auf eine Druckschablonenunterseite 16 der Druckschablone 8, und nach unten in Richtung auf eine Substratoberseite 17 des Substrats 6, also auf eine Bedruckungsseite 18 des Substrats 6. Auf diese Weise kann die Inspektionseinheit 1 auch zum Ausrichten von Substrat 6 und Druckschablone 8 relativ zueinander, nämlich in Hinblick auf ihre Horizontal-Anordnung, verwendet werden. Hierzu sind beispielsweise sowohl an der Druckschablonenunterseite 16 als auch an der Substratoberseite 17 Passermarken 19 vorgesehen, die von der Inspektionseinheit 1 durch ihre nach oben und unten entgegengesetzten Blickrichtungen 15 erfasst werden können. Auf diese Weise ist über eine Verschiebung des Substrats 6 und/oder der Druckschablone 8 eine sehr einfache und hochpräzise Ausrichtung von Substrat 6 und Druckschablone 8 relativ zueinander möglich. Die Inspektionseinheit 1 wird vor dem Bedrucken aus dem Bereich 20, der sich durch den Vertikalabstand 13 zwischen Substrat 6 und Druckschablone 8 ergibt, herausgefahren, und zum Zwecke der Inspektion nach erfolgtem Bedruckungsvorgang, also zur Inspektion des Druckergebnisses, wieder in den Bereich 20 eingefahren, nachdem Substrat 6 und Druckschablone 8 in vertikaler Richtung zur Erreichung des Vertikalabstands 13 voneinander abgehoben wurden, ohne dass aber die horizontale Relativausrichtung von Substrat 6 und Druckschablone 8 verändert wurde. Ergibt die Inspektion durch die Inspektionseinheit 1, dass das Druckergebnis nicht mindestens einer Vorgabe entspricht, also die erzielten Druckstrukturen 11 nicht erwartungsgemäß sind, kann nach Ausfahren der Inspektionseinheit 1 aus dem Bereich 20 und erneutem Aufeinanderlegen von Druckschablone 8 und Substrat 6 ein erneuter Bedruckungsvorgang erfolgen. Da sich die Horizontalausrichtung von Druckschablone 8 und Substrat 6 nicht verändert hat, ist ein exaktes Wiederauflegen der Druckschablone 8 auf das bereits bedruckte Substrat 6 möglich, so dass über die Rakeleinrichtung 9 eventuell zu wenig aufgetragene Lotpaste 10 in einem erneuten Bedruckungsvorgang korrigierend aufgetragen werden kann. Ebenso ist es möglich, zuviel aufgetragene Lotpaste 10, also eine zu hoch ausgebildete Druckstruktur 11, nach erneutem passgenauem Auflegen der Druckschablone 8 auf das Substrat 6 mittels des Rakels 9 abzunehmen, so dass die Druckstrukturen 11 eine gewünschte Druckauftragsstärke 21 aufweisen. Die Druckauftragstärke 21 kann hierbei sehr einfach verstanden werden als eine Höhe 22, die durch die Druckstrukturen 11 über der Substratoberseite 17 ausgebildet werden soll.

Erst wenn die Inspektion durch die Inspektionseinheit 1 das erwartete Druckergebnis ergibt, wird das bedruckte Substrat 6 aus der Druckeinrichtung 2 ausgestoßen beziehungsweise hinausgefördert. Auf diese Weise wird eine Ausschussproduktion in sehr vorteilhafter Weise vermieden. Die Kontrolle des Druckergebnisses kann nämlich noch innerhalb der Druckeinrichtung 2 erfolgen, so dass ein Korrigieren eines nicht erwartungsgemäß ausgefallenen Druckergebnisses noch in der Druckeinrichtung 2 möglich ist.

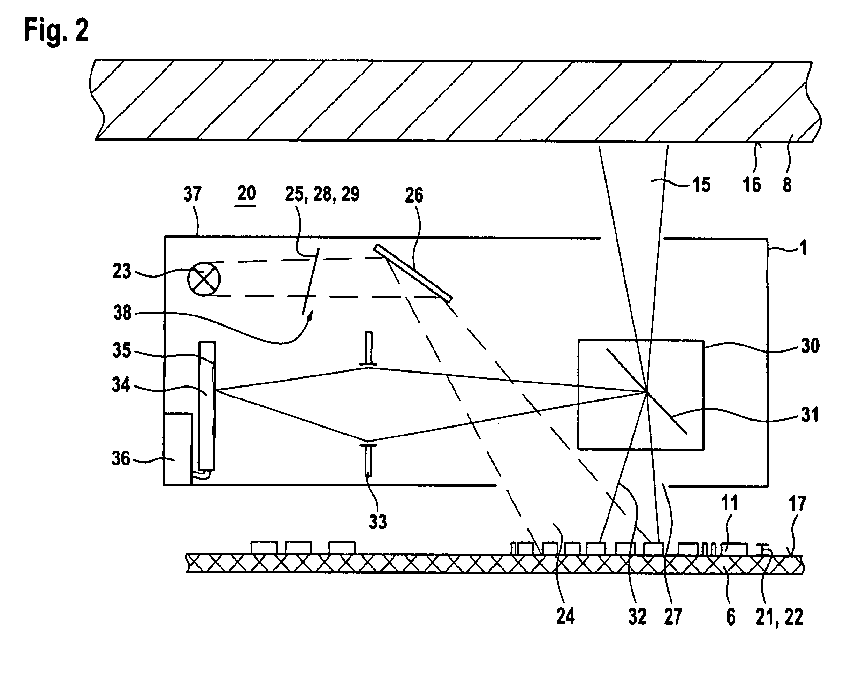

Figur 2 zeigt in schematischer Schnittdarstellung die Inspektionseinheit 1 in einer Inspektionsposition im Bereich 20 zwischen dem mit Druckstrukturen 11 bedruckten Substrat 6 und der Druckschablone 8. Die Inspektionseinheit 1 weist in einem Gehäuse 37 eine Lichtquelle 23 auf, in deren Strahlengang zur Bewirkung einer Streifenlichtprojektion 24 auf die Druckstrukturen 11 des Substrats 6 ein Linienmuster 25 angeordnet ist, das über einen Umlenkspiegel 26, von der Lichtquelle 23 durchleuchtet, durch eine Unterseitenöffnung 27 der Inspektionseinheit 1 schräg auf das Substrat 6 und die dort angeordneten Druckstrukturen 11 projiziert wird. Anstelle eines einfachen Linienmusters 25, beispielsweise als Durchsichtvorlage 28, kann auch ein Linienmustergenerator 29 zur Erzeugung eines Wechsellinienmusters verwendet werden, um wechselnde/unterschiedliche Linienmuster 25 in Folge oder alternativ schräg auf das Substrat 6 und die darauf angeordneten Drucksstrukturen 11 projizieren zu können. Hierdurch wird eine Streifenlichtprojektionseinrichtung 38 ausgebildet. Die Inspektionseinheit 1 weist ferner, bevorzugt in innenseitig im Gehäuse 37 angeordneter Gegenüberlage der Unterseitenöffnung 27 oder eines Abschnitts der Unterseitenöffnung 27, eine Spiegeleinrichtung 30 auf, die mindestens einen teildurchlässigen Spiegel 31 aufweist, der durch die Unterseitenöffnung 27 einen das Substrat 6 auf seiner Substratoberseite 17 erfassenden Auswertungsstrahlengang 32 durch eine verstellbare Blende 33, gegebenenfalls durch eine zusätzliche Optik, auf einen Detektor 34 lenkt, der als Kamera oder Zeilensensor ausgebildet ist. Der Detektor 34 erfasst ein Bild 35 von der mit Druckstrukturen 11 bedruckten Substratoberseite 17 und führt dieses Bild 35 einer Auswerteeinrichtung 36 zu. Die Auswerteeinrichtung 36 ermittelt aus den durch von der Höhe 22 der Druckstrukturen 11 bewirkten optischen Verzerrungen des projizierten Linienmusters 25 der Streifenlichtprojektion 24 die Höhe 22 im Wege der Triangulation. Auf diese Weise lässt sich eine quantitative Aussage darüber treffen, ob die Druckauftragsstärke 21, nämlich die erfasste Höhe 22 der Druckstrukturen 11 über der Substratoberseite 17, der geforderten Vorgabe entspricht, das Druckergebnis also zufriedenstellend ist, oder ob der Druckvorgang korrigiert werden muss.

Mittels der Blickrichtung 15 in Richtung auf die Druckschablonenunterseite 16 lässt sich, wie bereits zu Figur 1 beschrieben, die Ausrichtung von Substrat 6 und Druckschablone 8 relativ zueinander (in X-/Y-Richtung) korrigieren und auch während der Inspektion des Druckergebnisses die horizontale, in X-/Y-Richtung liegende Entsprechung von Druckstrukturen 11 mit den von der Druckschablone 8 vorgegebenen Positionen prüfen.

### BEZUGSZEICHENLISTE

- 1: Inspektionseinheit
- 2: Druckeinrichtung
- 3: Platinendrucker
- 4: Drucktisch
- 5: Abstützung
- 6: Substrat
- 7: Leiterplatte
- 8: Druckschablone
- 9: Rakeleinrichung
- 10: Lotpaste
- 11: Druckstruktur
- 12: Pads
- 13: Vertikalabstand
- 14: Verschiebevorrichtung
- 15: Blickrichtung
- 16: Druckschablonenunterseite
- 17: Substratoberseite
- 18: Bedrucksungsseite
- 19: Passermarke
- 20: Bereich
- 21: Druckauftragsstärke
- 22: Höhe
- 23: Lichtquelle
- 24: Steifenlichtprojektion
- 25: Linienmuster
- 26: Umlenkspiegel
- 27: Unterseitenöffnung
- 28: Durchsichtvorlage
- 29: Linienmustergenerator
- 30: Spiegeleinrichtung
- 31: teildurchlässiger Spiegel
- 32: Auswertungsstrahlengang
- 33: Blende
- 34: Detektor
- 35: Bild
- 36: Auswerteeinrichtung
- 37: Gehäuse
- 38: Streifenlichtprojektionseinrichtung

## Patentansprüche

1. Verfahren zum Bedrucken eines Substrats (6), insbesondere einer Leiterplatte (7), mit einer Druckpaste, insbesondere Lotpaste (10), mit folgenden Schritten:
- Auflegen einer Druckschablone (8) auf das Substrat (6),
- Bedrucken des Substrats (6) in Siebdrucktechnik durch Öffnungen der Druckschablone (8) hindurch zur Erzielung von mindestens einer aus Druckpaste bestehenden Druckstruktur (11),
- Trennen von Druckschablone (8) und Substrat (6) durch Abheben dieser Teile (6,8) voneinander,
- Einfahren einer optischen Inspektionseinheit (1),
- Prüfen der Druckstruktur (11) hinsichtlich ihrer Druckpastendicke mittels der Inspektionseinheit (1),
- Beendigen des Bedruckens, wenn das Druckergebnis mindestens einer Vorgabe entspricht,
**dadurch gekennzeichnet, dass** das Einfahren der optischen Inspektionseinheit (1) zwischen Druckschablone (8) und Substrat (6) erfolgt und die Inspektionseinheit (1) auch für ein Ausrichten von Druckschablone (8) und Substrat (6) relativ zueinander verwendet wird.

2. Verfahren nach Anspruch 1, mit den weiteren Schritten:
- Mindestens einmaliges Korrigieren der Bedruckung durch nochmaligen Bedruckungsvorgang nach vorherigem Herausfahren der Inspektionseinheit (1) aus der Position zwischen Druckschablone (8) und Substrat (6), falls die Vorgabe nicht erreicht ist; und nochmaliges Prüfen mittels der Inspektionseinheit (1).

3. Verfahren nach einem der vorhergehenden Ansprüche, **dadurch gekennzeichnet, dass** das Prüfen unter Zuhilfenahme einer Streifenlichtprojektion durchgeführt wird.

4. Verfahren nach einem der vorhergehenden Ansprüche, **dadurch gekennzeichnet, dass** das Prüfen an einem zuvor festlegbaren Abschnitt der Druckstruktur (11) und/oder Substrats (6) erfolgt.

5. Verfahren nach einem der vorhergehenden Ansprüche, **gekennzeichnet durch** eine mittels der Inspektionseinheit (1) erfolgende Prüfung der Fläche der Druckstruktur (11).

6. Inspektionseinheit (1) für eine Druckeinrichtung (2) zum Bedrucken eines Substrats (6), insbesondere einer Leiterplatte (7), mit einer Druckpaste, insbesondere Lotpaste (10), wobei die Inspektionseinheit (1) dem optischen Prüfen einer Druckstruktur (11) dient, **dadurch gekennzeichnet, dass** die Inspektionseinheit (1) zwischen einer Druckschablone (8) und dem Substrat (6) ein- und ausfahrbar angeordnet ist und auch für ein Ausrichten von Druckschablone (8) und Substrat (6) relativ zueinander verwendet wird, und dass mindestens eine Streifenlichtprojektionseinrichtung (38), die mindestens ein Linienmuster (25) schräg auf die zu prüfende Druckstruktur (11) wirft, und mindestens ein Detektor (34) zur Erfassung des Linienmusters (25) auf der Druckstruktur (11) vorgesehen sind.

7. Inspektionseinheit (1) nach Anspruch 6, **gekennzeichnet durch** mindestens eine Spiegeleinrichtung (30), die mindestens einen teildurchlässigen Spiegel (31) aufweist, der im Strahlengang der Inspektionseinheit (1) liegt.

8. Inspektionseinheit (1) nach einem der vorhergehenden Ansprüche, **gekennzeichnet durch** eine Auswerteeinrichtung (36) zur Auswertung eines vom Detektor (34) erfassten Bildes (35).

9. Inspektionseinheit (1) nach einem der vorhergehenden Ansprüche, **gekennzeichnet durch** eine Steuerschnittstelle zur Ansteuerung der Druckeinrichtung (2) in Abhängigkeit von einem Ergebnis einer von der Auswerteeinrichtung (36) durchgeführten Auswertung.

10. Druckeinrichtung (2), insbesondere Platinendrucker (3), mit einer Inspektionseinheit (1) nach einem oder mehreren der vorhergehenden Ansprüche, insbesondere zur Durchführung des Verfahrens nach einem der vorhergehenden Ansprüche.

## Claims

1. Method for printing a substrate (6), in particular a printed circuit board (7), with a printing paste, in particular solder paste (10), comprising the following steps:
- applying a printing screen (8) onto the substrate (6),
- printing the substrate (6) using screen printing technology through openings in the printing screen (8) so as to achieve at least one printed structure (11) consisting of printing paste,
- separating the printing screen (8) and the substrate (6) by lifting these parts (6, 8) off of each other,
- inserting an optical inspection unit (1),
- inspecting the printed structure (11) in terms of its printing paste thickness by means of the inspection unit (1),
- ending the printing when the result of the printing corresponds to at least one preset value,
**characterized in that** the insertion of the optical inspection unit (1) takes place between printing screen (8) and substrate (6) and that the inspection unit (1) is also used for an alignment of printing screen (8) and substrate (6) relative to each other.

2. Method according to claim 1, comprising the further steps:
- at least one-time correction of the printing by repeating the print process after the prior removal of the inspection unit (1) from the position between the printing screen (8) and the substrate (6), if the preset value has not been reached; and re-inspection by means of the inspection unit (1).

3. Method according to any one of the preceding claims, **characterized in that** the inspection is conducted by means of light stripe projection.

4. Method according to any one of the preceding claims, **characterized in that** the inspection is conducted on a section of the printed structure (11) and/or substrate (6) to be defined in advance.

5. Method according to any one of the preceding claims, **characterized in that** the surface of the printed structure (11) is inspected by means of the inspection unit (1).

6. Inspection unit (1) for a printing device (2) for printing a substrate (6), in particular a printed circuit board (7), by means of a printing paste, in particular solder paste (10), wherein the inspection unit (1) is used for the optical inspection of a printed structure (11), **characterized in that** the inspection unit (1) is arranged insertable and removable between a printing screen (8) and the substrate (6), and is also used for an alignment of printing screen (8) and substrate (6) relative to each other, and that at least one light stripe projection device (38), which projects at least one line pattern (25) diagonally onto the printed structure (11) to be inspected, and at least one detector (34) for detecting the line pattern (25) on the printed structure (11) are provided.

7. Inspection unit (1) according to claim 6, **characterized by** at least one mirror device (30), comprising at least one semipermeable mirror (31) located in the beam path of the inspection unit (1).

8. Inspection unit (1) according to any one of the preceding claims, **characterized by** an evaluation device (36) for evaluating an image (35) captured by the detector (34).

9. Inspection unit (1) according to any one of the preceding claims, **characterized by** a control interface for activating the printing device (2) depending on a result of an evaluation conducted with the evaluation device (36).

10. Printing device (2), in particular PCB printer (3), with an inspection unit (1) according to one or a plurality of the preceding claims, in particular for performing the method according to any one of the preceding claims.

## Revendications

1. Procédé pour imprimer un substrat (6), notamment une carte de circuit imprimé (7), avec une pâte d'impression, notamment une pâte à braser (10), avec les étapes suivantes :
- imposer un pochoir d'impression (8) sur le substrat (6),
- imprimer le substrat (6) à travers des ouvertures dans le pochoir d'impression (8) au moyens de sérigraphie, pour obtenir au moins une structure imprimée (11) consistant en pâte d'impression,
- séparer le pochoir d'impression (8) et le substrat (6) par enlèvement de cettes parties (6, 8) l'une de l'autre,
- insérer une unité d'inspection (1) optique,
- vérifier la structure imprimée (11) en vue de l'épaisseur de la pâte d'impression au moyen de l'unité d'inspection (1),
- terminer l'impression lorsque le résultat d'impression correspond à au moins un objectif prédéfini,
**caractérisé en ce que** l'unité d'inspection (1) optique est inserée entre le pochoir d'impression (8) et le substrat (6), et l'unité d'inspection (1) est aussi utilisée pour un alignement du pochoir d'impression (8) et du substrat (6) l'un par rapport à l'autre.

2. Procédé selon la revendication 1, avec les étapes suivantes:
- si l'objectif prédéfini n'est pas obtenu, au moins une fois corriger l'impression au moyens d'une impression réitérée après retirage de l'unité d'inspection (1) de la position entre le pochoir d'impression (8) et le substrat (6) ; et encore une fois vérifier l'impression au moyen de l'unité d'inspection (1).

3. Procédé selon l'une quelconque des revendications précédentes, **caractérisé en ce que** la vérification est effectuée par recours à une projection de lumière structurée.

4. Procédé selon l'une quelconque des revendications précédentes, **caractérisé en ce que** la vérification est effectuée sur une partie prédéfinissable de la structure imprimée (11) et/ou du substrat (6).

5. Procédé selon l'une quelconque des revendications précédentes, **caractérisé par** une vérification de la surface de la structure imprimée (11) s'effectuant au moyen de l'unité d'inspection (1).

6. Unité d'inspection (1) pour un dispositif d'impression (2) pour imprimer un substrat (6), notamment une carte de circuit imprimé (7), avec une pâte d'impression, notamment une pâte à braser (10), ladite unité d'inspection (1) étant destinée à la vérification optique d'une structure imprimée (11), **caractérisée en ce que** l'unité d'inspection (1) est disposée de manière à être insérée et retirée entre un pochoir d'impression (8) et le substrat (6), et est aussi utilisée pour un alignement du pochoir d'impression (8) et du substrat (6) l'un par rapport à l'autre, et **en ce qu'**au moins un dispositif à projection de lumière structurée (38) qui projette au moins un motif linéaire (25) de manière inclinée sur la structure imprimée (11) à vérifier, et au moins un détecteur (34) pour l'acquisition dudit motif linéaire (25) sur la structure imprimée sont prévus.

7. Unité d'inspection (1) selon la revendication 6, **caractérisée par** au moins un dispositif à miroir (30) qui présente au moins un miroir (31) semi-transparent disposé dans la trajectoire des rayons de l'unité d'inspection (1).

8. Unité d'inspection (1) selon l'une quelconque des revendications précédentes, **caractérisée par** un dispositif d'évaluation (36) pour l'évaluation d'une image (35) acquise par le détecteur (34).

9. Unité d'inspection (1) selon l'une quelconque des revendications précédentes, **caractérisée par** une interface de commande pour commander le dispositif d'impression (2) en fonction d'un résultat d'une évaluation effectuée par le dispositif d'évaluation (36).

10. Dispositif d'impression (2), notamment imprimante (3) des cartes à circuit imprimé, avec une unité d'inspection (1) selon une ou plusieurs des revendications précédentes, notamment pour réaliser le procédé selon l'une quelconque des revendications précédentes.
